(19) **Europäisches Patentamt**

**European Patent Office**

**Office européen des brevets**

(11) Veröffentlichungsnummer: **0 185 303 B1**

(12) **EUROPÄISCHE PATENTSCHRIFT**

(45) Veröffentlichungstag der Patentschrift: **29.07.92**

(21) Anmeldenummer: **85115737.0**

(22) Anmeldetag: **10.12.85**

(51) Int. Cl.⁵: **H05K 3/06**, H05K 3/34

(54) **Elektrisch leitende Kupferschichten und Verfahren zur Herstellung derselben.**

(30) Priorität: **19.12.84 DE 3446319**
**11.05.85 DE 3517009**

(43) Veröffentlichungstag der Anmeldung:
**25.06.86 Patentblatt 86/26**

(45) Bekanntmachung des Hinweises auf die
Patenterteilung:
**29.07.92 Patentblatt 92/31**

(84) Benannte Vertragsstaaten:
**AT BE CH DE FR GB IT LI NL SE**

(56) Entgegenhaltungen:
**DE-A- 2 823 068**
**DE-A- 2 930 666**
**US-A- 3 677 828**
**US-A- 3 941 628**

(73) Patentinhaber: **Blasberg-Oberflächentechnik
GmbH
Postfach 13 02 51 Merscheider Strasse 165
W-5650 Solingen 13(DE)**

(72) Erfinder: **Hupe, Jürgen, Dr.
Carl-Diem-Weg 14
W-4018 Langenfeld(DE)**
Erfinder: **Breidenbach, Herbert
Bauermannskulle 59
W-5650 Solingen 1(DE)**
Erfinder: **Sonnenschein, Frank
Charlottenstrasse 11
W-5650 Solingen 19(DE)**

(74) Vertreter: **Werner, Hans-Karsten, Dr. et al
Deichmannhaus am Hauptbahnhof
W-5000 Köln 1(DE)**

**Beschreibung**

Die vorliegende Erfindung betrifft Leiterplatten auf Basis von Grundplatten, auf welche eine mit einem säurelöslichen Überzug versehene elektrisch leitende Kupferschicht aufgetragen ist, ein Verfahren zur Herstellung und die Verwendung derselben.

Verfahren zur Herstellung von elektrisch leitenden Kupferschichten in Leiterplatten und Bauteilen sind bekannt. So werden Leiterplatten in Additiv-, Semi-Additiv- und Subtraktivtechniken hergestellt. Der weitaus größte Teil leitender Kupferschichten in hochwertigen, durchkontaktierten Leiterplatten wird auf dem subtraktiven Wege gefertigt. Hierbei hat die Metallresist-Technik, d.h. die Verwendung von Metallen wie Zinn, Blei oder Blei-Zinn-Legierungen als Ätzschutz große Bedeutung. Aus den dem Fachmann bekannten Gründen werden heute jedoch zunehmend sogenannte Kupferschaltungen hergestellt. Eine häufig bevorzugte Fertigungsmethode für Kupferschaltungen ist die sogenannte Metallresist-Stripp-Technik. Die Durchkontaktierung und der Leiterbildaufbau mit Kupfer erfolgen wie in der Metallresist-Technik. Die nicht zum Leiterbild gehörenden Kupferflächen sind mit einem Resist beschichtet. Bei den Resistschichten kann es sich beispielsweise um Photoresiste oder um im Siebdruckverfahren hergestellte Schichten handeln. Bei der Metallresist-Stripp-Technik wird in einer ersten Stufe auf die resistfreien Kupferflächen Zinn, Blei oder eine Blei/Zinnlegierung als Ätzschutz aufgebracht. In einer zweiten Stufe werden die Resiste vorzugsweise alkalisch-wässrig oder mit Lösungsmitteln weggewaschen. Anschließend wird das Kupfer in den nunmehr vom Resist befreiten Bereichen durch Ätzen entfernt. Hierzu werden meist ammoniakalische Kupferchloridlösungen verwendet. Teilweise kommt auch noch Eisenchlorid ($FeCl_3$) zum Einsatz. Ebenso wird vereinzelt mit Schwefelsäure und Peroxid gearbeitet.

Die Blei-, Zinn-, und Blei/Zinnschichten sind sowohl gegen ammoniakalische Kupferchloridlösungen als auch gegen die Schwefelsäure/Peroxid-Behandlung beständig.

In einer vierten Stufe muß die aus Blei-, Zinn-, Blei/Zinn-Legierungen bestehende Schicht entfernt werden. Hierfür werden z.B. peroxid- und fluoridhaltige Lösungen oder Salzsäure mit weiteren Zusätzen verwendet. Ein Verbleiben der metallischen Ätzschutzschichten (Metallresist-Technik) ist unerwünscht, weil sich beim Lötprozeß durch thermische Belastung unter den Lötstopplackschichten sogenannte Orangenhaut ausbildet. Dieser Effekt beruht auf dem relativ niedrigen Schmelzpunkt der metallischen Ätzschutzschicht.

Ein wesentlicher Nachteil der Metallresist-Stripp-Technik ist die Notwendigkeit in einem zusätzlichen Arbeitsschritt die Metallschicht wieder entfernen zu müssen. Dies ist aus rohstoffökonomischen und technischen Gründen sowie Kostengründen unerwünscht. Das Verfahren des Metallstrippens ist außerdem deshalb problematisch, weil teilweise auch das Kupfer angegriffen wird. Ferner treten bei unvollständiger Entfernung der Metallschutzschicht Schwierigkeiten beim Aufbringen des Lötstopplacks auf. Falls in den Bohrungen Reste verbleiben, ist später ein sauberes Verlöten der Bestückung nicht gewährleistet.

Um eine bessere Haftung des Lötstopplacks auf den Kupferbahnen zu sichern, werden diese häufig nach dem Entfernen der Metallschutzschicht schwarz oxidiert. Ursprünglich diente und dient die Schwarzoxidation beim Verpressen von Kupferfolien und Basismaterial der verbesserten Haftung zwischen Harzschicht und Kupferfolie.

Heute wird die Schwarzoxidation auch wegen der besseren optischen Eigenschaften der Leiterplatten angewandt.

Das Verfahren der Schwarzoxidation wird ausschließlich in alkalischen Medien durchgeführt. Die Behandlung wird bei Temperaturen von 50°C bis 90°C in hochalkalischen chlorithaltigen Lösungen durchgeführt ($NaOH$ + $NaClO_2$). Die erhaltenen Schichten sind zwar temperaturbeständig und neigen während des Lötvorgangs nicht zu der oben erwähnten "Orangenhaut". Die mechanische Beständigkeit und die Dicke dieser Schichten ist aber nicht ausreichend groß, so daß sie nicht als Ätzschutzschichten dienen können. Da die Oxidation bei relativ hohen Temperaturen durchgeführt wird, können negative Auswirkungen auf das Basismaterial auftreten.

Ein weiterer Nachteil der geschilderten Methode ist, daß im alkalischen Milieu gearbeitet werden muß. Infolgedessen ist diese Schwarzoxidation nur anwendbar, wenn die alkalilösliche Photoresistschicht ihre Funktion erfüllt hat, weggewaschen worden ist und das darunterliegende Kupfer weggeätzt worden ist.

Im Anschluß an die Schwarzoxidation wird der Lötstopplack (Lötmaske) aufgedruckt. Dabei bleiben die späteren Lötstellen ohne Lackschicht. Das gilt insbesondere für die Lötaugen und Lötlöcher. An den lackfreien Stellen muß die Schwarzoxidschicht wieder entfernt werden. Dies erfolgt mit verdünnter Salzsäure oder Peroxidlösungen. Auch dieses Verfahren ist nicht unproblematisch, weil es bei unvollständiger Entfernung der Oxidschicht zu Fehlern beim Löten kommen kann.

In einem abschließenden Schritt werden die vom Oxid befreiten Bereiche selektiv verzinnt bzw. verbleizinnt. Diese Maßnahme dient der Verbesserung der Lötfähigkeit. Außerdem bildet die Schicht einen Korrosionsschutz für das Kupfer.

Eine weitere Möglichkeit der Herstellung von Leiterplatten in Kupfertechnik nach dem Stand der Technik besteht darin, die nicht durch Resist abgedeckten Kupferschichten zu ätzen. Die Bohrungen, die bereits durchkontaktiert sind, und die Leiterbahnen werden dabei mit einer Schutzschicht aus Photoresist versehen (Tenting). Der Nachteil dieses Verfahrens ist, daß sehr viel Kupfer und Ätzmittel verbraucht werden. Außerdem ist eine sehr gleichmäßige Verkupferung erforderlich, um gute Ergebnisse zu erzielen. Eine weitere Möglichkeit ist das sogenannte Differenzätzen in Verbindung mit der Semi-Additiv-Technik. Nachteilig beim Differenzätzen ist die Vorbedingung einer absolut gleichmäßigen Schichtdickenverteilung des galvanisch abgeschiedenen Kupfers, sowohl auf der Oberfläche als auch in den Bohrungen.

Aus der DE-OS 29 30 666 sind ferner Leiterplatten bekannt, die als Ätzresist auf dem beim Leiterplattenaufbau galvanisch abgeschiedenen Kupfer eine Schicht aus einer Kupferverbindung aufweisen, die gegenüber Ätzmitteln beständig ist. Als Ätzresist wird vorzugsweise eine durch Oberflächentransformation des galvanisch abgeschiedenen Kupfers gebildete Kupfer(II)-Oxid-Schicht verwendet, d.h. der Resist wird auf chemischem Wege hergestellt. Die Leiterplatten werden hierbei mit der zuvor beschriebenen alkalischen Chloritlösung behandelt, bis 0,5 bis 5 $\mu$m der Kupferschicht in Kupfer(II)-Oxid umgewandelt sind.

Eine gleichmäßige Beschichtung ist mit einer solchen Kupfer(II)-Oxid-Schicht jedoch nicht möglich. Insbesondere bei dickeren Schichten bekommt man eine zunehmend amorphe Struktur. Das Verfahren gemäß der DE-OS 29 30 666 hat sich darüber hinaus als praktisch nicht durchführbar erwiesen.

Die vorliegende Erfindung hat sich die Aufgabe gestellt, die eingangs genannten Leiterplatten und Bauteile mit einem verbesserten Überzug zu versehen. Ferner ist es Aufgabe der vorliegenden Erfindung, ein vereinfachtes und verbessertes Verfahren zur Herstellung von Leiterplatten mit einem Überzug zu entwickeln.

Diese Aufgabe wird erfindungsgemäß dadurch gelöst, daß der säurelösliche Überzug ein im sauren Milieu auftragbares Schwarzmetall ist.

Hergestellt werden die Leiterplatten erfindungsgemäß durch ein Verfahren, bei welchem

a) mit einer elektrisch leitenden Kupferschicht beschichtete und mit gegebenenfalls durchkontaktierten Löchern sowie mit einem Resist versehene Grundplatten an den freien Kupferflächen in saurem Medium galvanisch mit einem Schwarzmetallüberzug versehen werden,

b) der Resist und danach die dadurch freigelegten Kupferflächen durch Ätzen entfernt werden,

c) die Leiterplatten mit einer haftenden Lötmaske versehen werden,

d) an den durch die Lötmaske nicht abgedeckten Teilen der Schwarzmetallüberzug entfernt wird.

Gegebenenfalls werden die nach Entfernung des Schwarzmetallüberzugs freigelegten Kupferflächen mit einer gut lötbaren Metallschicht versehen.

Das erfindungsgemäße Verfahren geht von den fertigen mit Kupfer beschichteten und mit gegebenenfalls durchkontaktierten Löchern versehenen Leiterplatten aus. Die Kupferschicht kann beispielsweise galvanisch aufgetragen worden sein. Außerdem ist ein Teil der Kupferfläche noch mit einem Resist beschichtet. Hierbei kann es sich um Photoresistschichten oder im Siebdruckverfahren hergestellte Resistschichten handeln.

Überraschenderweise wurde erfindungsgemäß festgestellt, daß Schwarzmetallüberzüge auch als Ätzresist und haftverbessernde Abdeckschicht von elektrisch leitenden Kupferschichten verwendet werden können. Diese Schichten sind mechanisch und thermisch stabil. Hierzu lehrt R. Brugger (DE-Buch "Die galvanische Vernicklung", Eugen G. Leuze Verlag, Saulgau 1967) gerade das Gegenteil. Die Schwarznickelschichten sind danach nämlich sehr spröde. Ferner sei ihre Korrosionsbeständigkeit nur beschränkt und würde nur geringen Ansprüchen genügen. Daher müßten die Schichten lackiert oder mit Vaseline, Öl oder Fett eingerieben werden. Ferner sei die Verschleißfestigkeit der Schwarznickelniederschläge sehr gering. Außerdem würden sich die Niederschläge bei 180 °C zersetzen. Erfindungsgemäß wird jedoch das Gegenteil beobachtet. Kurzfristig halten die Schwarzchromschichten sogar 300 °C und mehr aus, was für die Zwecke der Bestückung und Lötung völlig ausreichend ist.

Gemäß der Erfindung wird auf die vom Resist befreiten Kupferflächen im sauren Milieu galvanisch der Schwarzmetallüberzug aufgebracht. Vorzugsweise handelt es sich um Schwarz-Chrom und Schwarz-Nickelüberzüge.

Weiterhin kommen auch andere galvanisch auftragbare Schwarzmetalle wie z.B. Cobalt, Silber oder Legierungen der genannten Metalle in Betracht. Ebenso kommen für die Abscheidung von Chrom dessen drei- und sechswertige Verbindungen in Betracht.

Prinzipiell kommen alle Schwarzmetallüberzüge in Frage, die chemisch oder galvanisch im sauren Milieu auftragbar sind, eine gut haftende, gegen alkalische Ätzung beständige, im sauren Milieu wieder vollständig entfernbare Schicht bilden, die optisch gut erkennbar ist. Die Farbe kann dabei von tiefschwarz bis grau oder braun variieren, sofern ein ausreichender optischer Kontrast zur Grundplatte entsteht. Diese Schwarzmetallüberzüge wurden bisher vor allem als Schwarzchrom- oder Schwarznickelüberzüge zu Dekorationszwecken verwendet. So ist aus dem "Handbuch der Galvanotechnik", Band II, Carl Hanser Verlag, München 1966, bekannt, daß Schwarzchromüberzüge mit guter Haftfestigkeit und guten optischen Schwarzkörpereigenschaften abgeschieden werden können. Allerdings sind nach den dortigen Ausführungen solche Schwarzchromüberzüge mechanisch nicht sehr beständig und werden bei scheuernder Beanspruchung leicht glänzend und dann unbrauchbar für die genannten Zwecke. Ferner schildert Robert Weiner ("Die galvanische Verchromung", Eugen Leuze Verlag, Saulgau 1974) die Herstellung matter, schwarzer Chromüberzüge, die sehr gute Strahlungseigenschaften besitzen. Gelegentlich werden solche Überzüge in optischen und thermischen Geräten sowie Röntgengeräten verwendet. Allerdings sind diese Überzüge nur von mäßiger Bedeutung, da die tiefmatten Überzüge bei mechanischer Beanspruchung und scheuernden Einwirkungen rasch glänzend werden und dann die gewünschte Wirksamkeit verlieren.

Neben den genannten Anwendungsgebieten wird die Schwarzverchromung aber auch in anderen Industriebereichen verwendet, z.B. bei Meß- und Kontrollgeräten, in der elektrotechnischen Industrie, im medizinischen Apparatebau und in der Automobilindustrie (vgl. C. Juhos, S. Gheorghe, E. Grünwald und C. Várhelyi, Galvanotechnik 75 (1984) 702).

Überraschenderweise sind Schwarzchrom- und Schwarznickelüberzüge auch ausgezeichnet geeignet, als Ätzresist und haftverbessernde Abdeckschicht von Leiterplatten der eingangs genannten Art verwendet zu werden. Diese Schichten sind mechanisch und thermisch bis mindestens 300°C beständig und gewährleisten eine hervorragende Haftfestigkeit für die auf den Leiterplatten verbleibenden Lötmasken. In einigen Fällen wird die Qualität der Schwarzmetallüberzüge dadurch verbessert, daß sie nicht unmittelbar auf das Kupfer sondern auf eine dünne Glanzmetallschicht von 0,5 bis 3 $\mu$m aufgebracht werden. Diese Glanzmetallschichten sind so dünn, daß sie ebenfalls gut und vollständig entfernt werden können.

Die Dicke der Schwarzchromschicht beträgt mindestens 0,1 $\mu$m, meist 0,1 bis 10 $\mu$m, vorzugsweise 0,5 bis 4 $\mu$m. Bei Nickel beträgt die Schichtdicke mindestens 0,1 $\mu$m, vorzugsweise 0,5 bis 2 $\mu$m. Ein besonders bevorzugter Bereich liegt bei 0,5 bis 1,5 $\mu$m. Überraschenderweise werden diese Schwarzchromschichten mit Stromdichten von etwa 3 - 10 A/dm$^2$ abgeschieden. Der Stand der Technik lehrt hingegen die Anwendung von Stromdichten oberhalb von 20 A/dm$^2$. Ein besonderer Vorteil der erfindungsgemäß verwendeten Schwarzmetallschichten ist ihre bessere mechanische und chemische Beständigkeit im Vergleich zu den bekannten Schwarzoxidschichten aus Kupfer.

Eine ähnlich gute Beständigkeit weisen auch die nach dem Stand der Technik vereinzelt verwendeten Matt-Nickelschichten auf. Ein Nachteil dieser Schichten ist, daß sie sich gegebenenfalls nur sehr schwer und nur unvollständig selektiv entfernen lassen. Die Lötbarkeit von Nickelschichten ist bekanntlich nicht unproblematisch.

In einer folgenden Stufe wird in üblicher Weise die Photoresistschicht mit wässrig alkalischen Mitteln oder mit organischen Lösungsmitteln entfernt. Anschließend erfolgt das Kupferätzen der vom Resist befreiten Kupferflächen. Hierfür werden meist alkalische Mittel, wie ammoniakalische Kupferchloridlösungen (CuCl$_2$) verwendet. Danach wird der Lötstopplack als Lötmaske aufgebracht, der auf der Schwarzmetallschicht der erfindungsgemäßen Leiterplatte besonders gut haftet.

In einem weiteren Verfahrensschritt wird an den vom Lötstopplack (der Lötmaske) nicht abgedeckten Stellen die Schwarzmetallschicht wieder entfernt. Bei diesem selektiven Ätzen werden insbesondere die Bohrungen und Lötaugen wieder freigelegt. Dieses Ätzen wird im sauren Milieu durchgeführt unter Verwendung von Mineralsäuren oder sauren Peroxidlösungen. Gewünschtenfalls werden in einem abschließenden Verfahrensschritt die vom Schwarzmetall befreiten Stellen des Kupfers verzinnt oder mit einer anderen gut lötbaren Metallschicht versehen. Das Verzinnen ist unproblematisch, da der Ätzschutz aus Schwarzmetall leicht und vollständig entfernt werden kann. Weiterhin ist der Korrosionsschutz der Schwarzmetallüberzüge besonders gut, zumal die Kupferbahnen größtenteils unter der gut haftenden Lötmaske verbleiben.

Die mechanische Festigkeit und Haftung der Lötmaske sind besser als bei den bisher bekannten Kupferoxidschichten. Insbesondere bei zu dicken Kupferoxidschichten sind nämlich die Hafteigenschaften der Lötmaske unbefriedigend.

Weitere Untersuchungen des Verfahrens zur Herstellung der elektrisch leitenden Kupferschichten haben gezeigt, daß die in saurem Milieu galvanisch aufgetragenen Schwarzmetallüberzüge an den durch die Lötmaske nicht abgedeckten Teilen stets dann einwandfrei in saurem Milieu wieder entfernt werden können, wenn sie nicht durch längere Einwirkung von Hitze künstlich gealtert sind. Beim Aushärten von Lötstoppmasken bei Temperaturen von etwa 100 bis 150°C treten aber zusätzlich Veränderungen in der Schwarzmetallschicht ein, die insbesondere beim Schwarzchrom dazu führen, daß nach dem Ätzen in Salzsäure Rückstände verbleiben, die bei der nachfolgenden selektiven Heißluftverzinnung zu fehlerhaften Leiterplatten führen können. Diese durch Alterung entstandenen Rückstände sind nur extrem schwer entfernbar. Verschiedene Lösungen auf Basis von Säuren mit verschiedenen Zusätzen brachten keine befriedigenden Ergebnisse.

Es wurde gefunden, daß es möglich ist, auch gealterte Schwarzmetallschichten rückstandslos zu entfernen durch netzmittelhaltige, alkalische Kaliumhexacyanoferrat(III)Lösungen. Diese Lösungen müssen mindestens 0,2 Mol/l Kaliumhexacyanoferrat(III) enthalten, können aber auch gesättigt sein. Der Gehalt an Kaliumhydroxid muß mindestens 0,1 Mol/l betragen und kann ohne weiteres auf 5 Mol/l erhöht werden. Der Gehalt an Netzmitteln sollte 0,001 bis 1 g/l betragen. Als Netzmittel kommen prinzipiell alle alkali- und oxidationsmittelunempfindlichen Mittel in Frage.

Das Verfahren der Entfernung der gealterten oder nicht gealterten Schwarzmetallüberzüge kann bei Temperaturen zwischen Raumtemperatur und 70°C durchgeführt werden. Unter diesen Bedingungen erfolgt kein schädlicher Angriff auf die Lötstoppmasken oder sonstige Teile der Leiterplatten. Die freigelegten Kupferflächen werden von der Lösung nicht angegriffen. Die erfindungsgemäß freigelegten Lötstellen können anschließend einwandfrei selektiv verzinnt bzw. verbleizinnt werden.

Durch die folgenden Ausführungsbeispiele wird die Erfindung näher erläutert:

**Beispiel 1**

Die Leiterbahnen und Bohrlochwandungen einer resistbedruckten Leiterplatte wurden in einem handelsüblichen Kupferelektrolyten, z.B. CUPROSTAR LP 1$^{(R)}$ x) auf 25 $\mu$m aufgekupfert. Nachdem die Platte gespült war, wurde sie anschließend mit einer nickeloxidhaltigen grau-schwarzen Schicht von ca. 1 $\mu$m versehen. Die Abscheidung erfolgte aus handelsüblichen Schwarznickelelektrolyten, z.B. "BLACK PEARL"$^{TM}$ xx). Die Abscheidungsparameter waren:

| pH-Wert: | 5,8 |
|---|---|
| Temperatur: | 30-32°C |
| Stromdichte: | 0,8-1 A/dm$^2$ |
| Expositionszeit: | ca. 5 Min. |

Nach dem Spülen und Trocknen wurde der Resist wässrigalkalisch entfernt und die freigelegten Kupferflächen in ammoniakalischer Kupferchloridlösung entfernt. Die Schwarznickelschicht brachte einen ausreichenden Ätzschutz.

Noch bessere Ergebnisse wurden erzielt, wenn zwischen die Kupfer- und die Schwarznickelschicht eine dünne Glanznickelschicht von ca. 3 $\mu$m aufgebracht wurde.

**Beispiel 2**

Wie im Beispiel 1 beschrieben wurden die aufgekupferten Leiterplatten gespült und nun mit einem handelsüblichen Schwarzchrombad, z.B. NEROSTAR CR$^{(R)}$ x) behandelt. In etwa 15 Min. wurden bei Stromdichten von ca. 15 A/dm$^2$ ungefähr 4 $\mu$m dicke Schwarzchromschichten abgeschieden. Die Arbeitstemperatur betrug ca. 20 bis 25°C; der pH-Wert war stark sauer ( 1).

x) ein Produkt der Blasberg-Oberflächentechnik GmbH

xx) ein Produkt der OMI International.

Die Schwarzchromschicht lieferte beim Ätzen in ammoniakalischer Kupferchloridlösung einen einwandfreien und ausgezeichneten Ätzschutz.

Die gemäß Beispiel 1 bis 2 behandelten Leiterplatten wurden anschließend jeweils so mit Lötstoppresist (Lötmasken) bedruckt, daß die Lötaugen und Bohrungen nicht abgedeckt waren. In diesen Bereichen wurde nun selektiv die Ätzschutzschicht wieder entfernt. Als letzter Schritt erfolgte eine Heißluftverzinnung. Die erfindungsgemäß behandelten Platten passierten diese letzten Prozeßschritte ebenfalls ohne jegliche Beanstandungen. Die Lötmasken wiesen auch danach ausgezeichnete Haftung auf, die darunterliegenden Kupferschichten waren mattschwarz und optisch gegenüber den Grundplatten gut abgesetzt. Die von der Ätzschutzschicht aus Schwarzmetall befreiten Kupferflächen nahmen das Zinn gut auf und lieferten stabile, einwandfreie Lötungen.

**Beispiel 3**

Durchkontaktierte und resistbedruckte Leiterplatten wurden in einem handelsüblichen Kupferelektrolyten, (z.B. CUPROSTAR$^{(R)}$ LP 1) auf 25 $\mu$m aufgekupfert und anschließend elektrolytisch mit einer ca. 2 bis 3 $\mu$m dicken Schwarzchromschicht beschichtet (Arbeitsbedingungen: 5 A/dm$^2$ Stromdichte, Expositionszeit: 20

min).

Nach dem Reststrippen und Entfernen (Ätzen) der überflüssigen Kupferfläche wurden die Platten so mit einer Lötstoppmaske abgedeckt, daß die Lötaugen und Bohrungen freiblieben. Die Aushärtung der Lötstoppmaske erfolgte je nach Typ bei Temperaturen von 100 bis 150°C. Anschließend wurde die Schwarzchromschicht von Lötaugen und Bohrungen selektiv entfernt durch eine Lösung von 260 g/l Kaliumhexacyanoferrat(III), 35 g/l Kaliumhydroxid und 0,035 g/l Netzmittel (Triton BG 10). Die Arbeitstemperatur betrug 40°C und die Expositionszeit 2 Min. Im Gegensatz zur sauren Entfernung von entsprechend gealterten Schwarzchromschichten wurden die Schwarzchromschichten rückstandlos entfernt. Anschließend war an diesen Stellen eine selektive Verzinnung bzw. Bleiverzinnung möglich.

Variationen der Konzentration von Kaliumhexacyanoferrat(III), der Konzentration an Kaliumhydroxid und Netzmittel, sowie schließlich in der Arbeitstemperatur und der Expositionszeit zeigten, daß in allen Fällen zuverlässig gute Bedingungen erzielt wurden.

**Beispiel 4**

Haftfestigkeit von Schwarznickel nach Temperung Die Schwarzvernickelung wurde bei 3,5 V 6 Minuten durchgeführt. Anschließend wurde bei 180 °C 8 Minuten getempert. Es wurde beim Schwarznickel keine Veränderung beobachtet, geschweige denn eine Ablösung vom Grundmaterial. Weitere Temperungsversuche wurden bei 130 °C und 30 Minuten und bei 130 °C und 120 Minuten durchgeführt. Auch hier wurde keine Veränderung bzw. Ablösung beobachtet.

Aus diesen Versuchen wird deutlich, daß Schwarznickel sich für die erfindungsgemäßen Zwecke einsetzen läßt. Eine physikalische Veränderung beim Tempern ist nicht erfolgt.

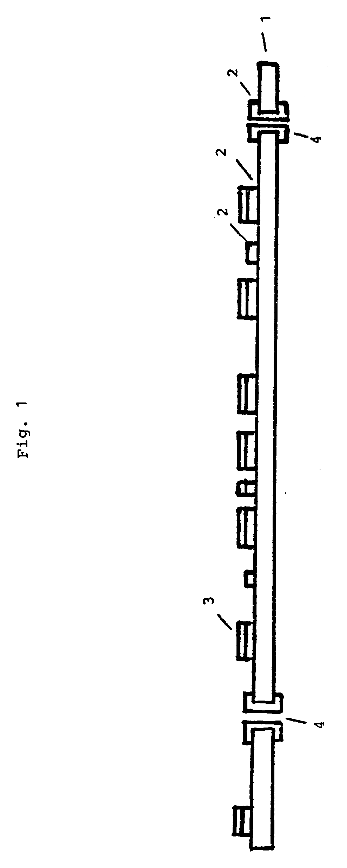

Der Aufbau einer typischen Leiterplatte mit elektrisch leitenden Kupferschichten und dem erfindungsgemäß verwendeten Überzug aus Schwarzmetall wird in der Fig. 1 näher erläutert. Darin bedeuten:
1) die Grundplatte
2) leitende Kupferschichten der Leiterbahnen
3) Schwarzmetallüberzüge
4) leitende Kupferschichten der durchkontaktierten Bohrungen.

Nicht gezeigt ist die Lötmaske, die insbesondere die Teile freiläßt, die noch verlötet werden sollen sowie gegebenenfalls Leiterbahnen und Lötstellen auf der Rückseite der Leiterplatte.

Die Schwarzmetallschichten können ebenso vorteilhaft beim Verpressen von Multilayern zur verbesserten Haftung zwischen Prepreg und Kupferfolie eingesetzt werden.

**Patentansprüche**

1. Leiterplatten auf Basis von Grundplatten (1), auf welche eine mit einem säurelöslichen Überzug (3) versehene elektrisch leitende Kupferschicht (2) aufgetragen ist, dadurch gekennzeichnet, daß der säurelösliche Überzug ein im sauren Milieu auftragbares Schwarzmetall ist.

2. Leiterplatten gemäß Anspruch 1, dadurch gekennzeichnet, daß der Überzug eine Schwarzchromschicht mit einer Stärke von mindestens 0,1 $\mu$m ist.

3. Leiterplatten gemäß Anspruch 2, dadurch gekennzeichnet, daß die Stärke 0,5 bis 4 $\mu$m ist.

4. Leiterplatten gemäß Anspruch 1, dadurch gekennzeichnet, daß der Überzug eine Schwarznickelschicht mit einer Stärke von mindestens 0,1 $\mu$m ist.

5. Leiterplatten gemäß Anspruch 4, dadurch gekennzeichnet, daß die Stärke 0,5 bis 1,5 $\mu$m ist.

6. Verfahren zur Herstellung von Leiterplatten, bei welchem
   a) mit einer elektrisch leitenden Kupferschicht beschichtete und mit gegebenenfalls durchkontaktierten Löchern sowie mit einem Resist versehene Grundplatten an den freien Kupferflächen in saurem Medium galvanisch mit einem Schwarzmetallüberzug versehen werden,
   b) der Resist und danach die dadurch freigelegten Kupferflächen durch Ätzen entfernt werden,
   c) die Leiterplatten mit einer haftenden Lötmaske versehen werden,
   d) an den durch die Lötmaske nicht abgedeckten Teilen der Schwarzmetallüberzug entfernt wird.

7. Verfahren nach Anspruch 6, dadurch gekennzeichnet, daß die nach Entfernung des Schwarzmetallüberzugs freigelegten Kupferflächen mit einer gut lötbaren Metallschicht versehen werden.

**8.** Verfahren gemäß einem der Ansprüche 6 und/oder 7, dadurch gekennzeichnet, daß als Schwarzmetallüberzug ein Schwarzchrom- oder Schwarznickelüberzug verwendet wird.

**9.** Verfahren gemäß einem der Ansprüche 6 bis 8, dadurch gekennzeichnet, daß der Schwarzmetallüberzug im sauren Milieu entfernt wird.

**10.** Verfahren gemäß einem der Ansprüche 6 bis 9, dadurch gekennzeichnet, daß im Schritt d) an den durch die Lötmaske nicht abgedeckten Teilen der Schwarzmetallüberzug entfernt wird durch eine netzmittelhaltige alkalische Kaliumhexacyanoferrat(III)Lösung.

**11.** Verfahren gemäß Anspruch 10, dadurch gekennzeichnet, daß die Entfernung bei Temperaturen von Raumtemperatur bis 70°C durchgeführt wird.

**12.** Verfahren gemäß Anspruch 10 oder 11, dadurch gekennzeichnet, daß die Lösung mindestens 0,2 Mol/l Kaliumhexacyanoferrat(III), 0,1 bis 5 Mol/l Kaliumhydroxid und 0,001 bis 1 g/l Netzmittel enthält.

**13.** Verwendung von im sauren Milieu auftragbaren Schwarzmetallschichten in Leiterplatten als Ätzresist und haftungsverbessernde Abdeckschicht auf elektrisch leitenden Kupferschichten, welche auf eine Grundplatte aufgetragen sind.

**Claims**

**1.** Printed circuit boards on the basis of base plates
(1) whereupon an electrically conductive copper layer
(2) provided with an acid-soluble coating (3), characterized in that the acid-soluble coating is a black metal coatable in acidic media.

**2.** Printed circuit boards according to claim 1, characterized in that the coating is a black chromium layer having a thickness of at least 0.1 $\mu$m.

**3.** Printed circuit boards according to claim 2, characterized in that the thickness is from 0.5 to 4 $\mu$m.

**4.** Printed circuit boards according to claim 1, characterized in that the coating is a black nickel layer having a thickness of at least 0.1 $\mu$m.

**5.** Printed circuit boards according to claim 4, characterized in that the thickness is from 0.5 to 1.5 $\mu$m.

**6.** A process for manufacturing printed circuit boards wherein
a) base plates coated with an electrically conductive copper layer and optionally provided with through-hole plating and a resist are galvanically provided at the free copper surfaces with a black metal coating in acidic medium;
b) the resist and subsequently the thus exposed copper surfaces are removed by etching;
c) the printed circuit boards are provided with an adhering solder resist;
d) the black metal coating is removed in the areas not covered by the soldering resist.

**7.** The process according to claim 6, characterized in that the copper surfaces exposed upon removal of the black metal coating are provided with a well-solderable metal layer.

**8.** Process according to one of the claims 6 and/or 7, characterized in that a black chromium or black nickel coating is used as the black metal coating.

**9.** Process according to one of the claims 6 to 8, characterized in that the black metal coating is removed in acidic medium.

**10.** Process according to one of the claims 6 to 9, characterized in that in step d) the black metal coating in the areas not covered by the soldering resist is removed by a surfactant-containing alkaline potassium hexacyanoferrate(III) solution.

**11.** The process according to claim 10, characterized in that said removal is carried out at temperatures of from room temperature to 70°C.

**12.** Process according to claim 10 or 11, characterized in that the solution contains at least 0.2 moles/l of potassium hexacyanoferrate(III), from 0.1 to 5 moles/l of potassium hydroxide and from 0.001 to 1 g/l of surfactant.

**13.** Use of black metal layers coatable in acidic medium in printed circuit boards as an etching resist and an adherence-improving cover layer on electrically conductive copper layers which are coated onto a base plate.

**Revendications**

**1.** Plaquettes pour circuits imprimés dont le principe repose sur l'emploi de substrats (1) sur lesquels est appliquée une couche de cuivre électriquement conductrice (2) pourvue d'un revêtement soluble dans l'acide (3), caractérisées en ce que le revêtement soluble dans l'acide est un métal noir applicable en milieu acide.

**2.** Plaquettes pour circuits imprimés selon la revendication 1, caractérisées en ce que le revêtement est une couche de chrome noir d'une épaisseur d'au moins 0,1 $\mu$m.

**3.** Plaquettes pour circuits imprimés selon la revendication 2, caractérisées en ce que l'épaisseur est de 0,5 à 4 $\mu$m.

**4.** Plaquettes pour circuits imprimés selon la revendication 1, caractérisées en ce que le revêtement est une couche de nickel noir d'une épaisseur d'au moins 0,1 $\mu$m.

**5.** Plaquettes pour circuits imprimés selon la revendication 4, caractérisées en ce que l'épaisseur est de 0,5 à 1,5 $\mu$m.

**6.** Procédé de fabrication de plaquettes pour circuits imprimés, dans lequel
a) des substrats, recouverts d'une couche de cuivre électriquement conductrice, avec des trous métallisés au besoin, ainsi qu'un vernis, sont pourvus par galvanisation en milieu acide, aux surfaces de cuivre libres, d'un revêtement de métal noir,
b) le vernis et ensuite les surfaces de cuivre ainsi mises à nu sont décapés,
c) les plaquettes pour circuits imprimés sont dotées d'un masque de brasage adhésif,
d) le revêtement métallique noir est éliminé des parties non cachées par le masque de brasage.

**7.** Procédé selon la revendication 6, caractérisé en ce que les surfaces de cuivre, mises à nu après élimination du revêtement métallique noir, sont recouvertes d'une couche métallique que l'on peut facilement braser.

**8.** Procédé selon l'une des revendications 6 et/ou 7, caractérisé en ce qu'un revêtement de nickel ou de chrome noirs est utilisé en tant que revêtement métallique noir.

**9.** Procédé selon l'une des revendications 6 à 8, caractérisé en ce que le revêtement métallique noir est éliminé en milieu acide.

**10.** Procédé selon l'une des revendications 6 à 9, caractérisé en ce que, dans l'étape d), le revêtement métallique noir est éliminé des parties non cachées par le masque de brasage, au moyen d'une solution alcaline d'hexacyanoferrate de potassium (III) contenant un agent mouillant.

**11.** Procédé selon la revendication 10, caractérisé en ce que l'élimination est effectuée à des températures allant de la température ambiante à 70°C.

**12.** Procédé selon la revendication 10 ou 11, caractérisé en ce que la solution contient au moins 0,2 mol/l d'hexacyanoferrate de potassium (III), de 0,1 à 5 mol/l d'hydroxyde de potassium et de 0,001 à 1 g/l de tensioactif.

13. Utilisation de couches métalliques noires applicables en milieu acide dans des plaquettes pour circuits imprimés, en tant que vernis de décapage et couche protectrice augmentant l'adhérence, sur des couches de cuivre électriquement conductrices qui sont appliquées sur un substrat.

Fig. 1